Europäisches Patentamt

European Patent Office

Office européen des brevets

(11) Veröffentlichungsnummer: **0 163 803**
**A2**

(12) # EUROPÄISCHE PATENTANMELDUNG

(21) Anmeldenummer: 85100250.1

(22) Anmeldetag: 12.01.85

(51) Int. Cl.⁴: **H 03 B 5/12**

(30) Priorität: 14.01.84 DE 3401531

(43) Veröffentlichungstag der Anmeldung: 11.12.85
Patentblatt 85/50

(84) Benannte Vertragsstaaten: **AT BE CH FR GB IT LI LU NL SE**

(71) Anmelder: **Jores, Heinrich, Europaring 78,
D-6090 Rüsselsheim 7 (DE)**

(72) Erfinder: **Jores, Heinrich, Europaring 78,
D-6090 Rüsselsheim 7 (DE)**

(54) **Sinusoszillator zur Erzeugung von ungedämpften elektrischen Schwingungen.**

(57)   Zur Kosteneinsparung und zur Reduzierung der vielen bisher bei der Erzeugung von ungedämpften elektrischen Schwingungen je nach Verwendungszweck eingesetzten Sinusoszillatorarten kann der hier beschriebene neue Oszillator (siehe Prinzipschaltbild, Version 1 und 2), der sich durch seinen einfachen schaltungstechnischen Aufbau, durch seine guten Schwing- und Abgleicheigenschaften und durch sein stabiles Schwingverhalten gegenüber den bekannten Oszillatoren auszeichnet, mit Erfolg eingesetzt werden.

   Durch eine geringe Abwandlung dieser Schaltung (Anschluß S des Mitkopplungswiderstandes $R_M$ direkt auf Nullpotential und kapazitive Signaleinkopplung auf den nicht invertierenden Operationsverstärkereingang E) kann dieser Oszillator in einen selektiven Verstärker umfunktioniert werden.

2.    Beschreibung der Erfindung

2.1    Einsatzbereich des neuen Oszillators

Die Erfindung betrifft einen Sinusoszillator, der zur besseren Unterscheidung im weiteren Verlauf der Beschreibung kurz ,, neuer Oszillator'' genannt wird.

Er ist, bedingt durch seinen einfachen, unkomplizierten Aufbau, sein stabiles Schwingverhalten und seine guten Schwingeigenschaften, einsetzbar in:

- Sendern
- Empfängern
- Kapazitiven und induktiven Wärmeerzeugern
- Sinusgeneratoren
- Tongeneratoren
- Sirenen
- Elektronischen Musikinstrumenten
- Vibratoren
- Frequenzumformern
- Meßgeräten
- Sensoren
- Steuerungen
- Sicherheitssystemen
- usw.

Diese Aufzählung kann nur als eine Andeutung der vielen Einsatzmöglichkeiten für diesen einfachen Oszillator angesehen werden.
Die mit dieser Erfindung zu lösenden Aufgaben und die durch diese Erfindung abgedeckten Bereiche dürften damit festliegen, d.h., die vielen Arten der bisher verwendeten Sinusoszillatoren können durch diesen Oszillator weitgehend ersetzt werden.

2.2    Stand der Technik

Bekannte Sinusoszillatoren zur Erzeugung von ungedämpften elektrischen Schwingungen sind:

- Meißner-Oszillatorschaltung
- Induktive Dreipunktschaltung, auch Hartley-Oszillator oder induktive Spannungsteilerschaltung genannt
- Kapazitive Dreipunktschaltung, auch Colpitts-Oszillator oder kapazitive Spannungsteilerschaltung genannt

0163803

- Phasenschieber-Generator
- Wien-Brücken-Generator
- Oszillatorschaltung mit Integratoren
- Huth-Kühn-Schaltung
- Franklin-Oszillatorschaltung
- Clapp-Oszillatorschaltung
- Kombinationsschaltung aus Clapp- und Franklin-Oszillator
- usw.

2.3    Allgemeiner Aufbau von Sinusoszillatoren

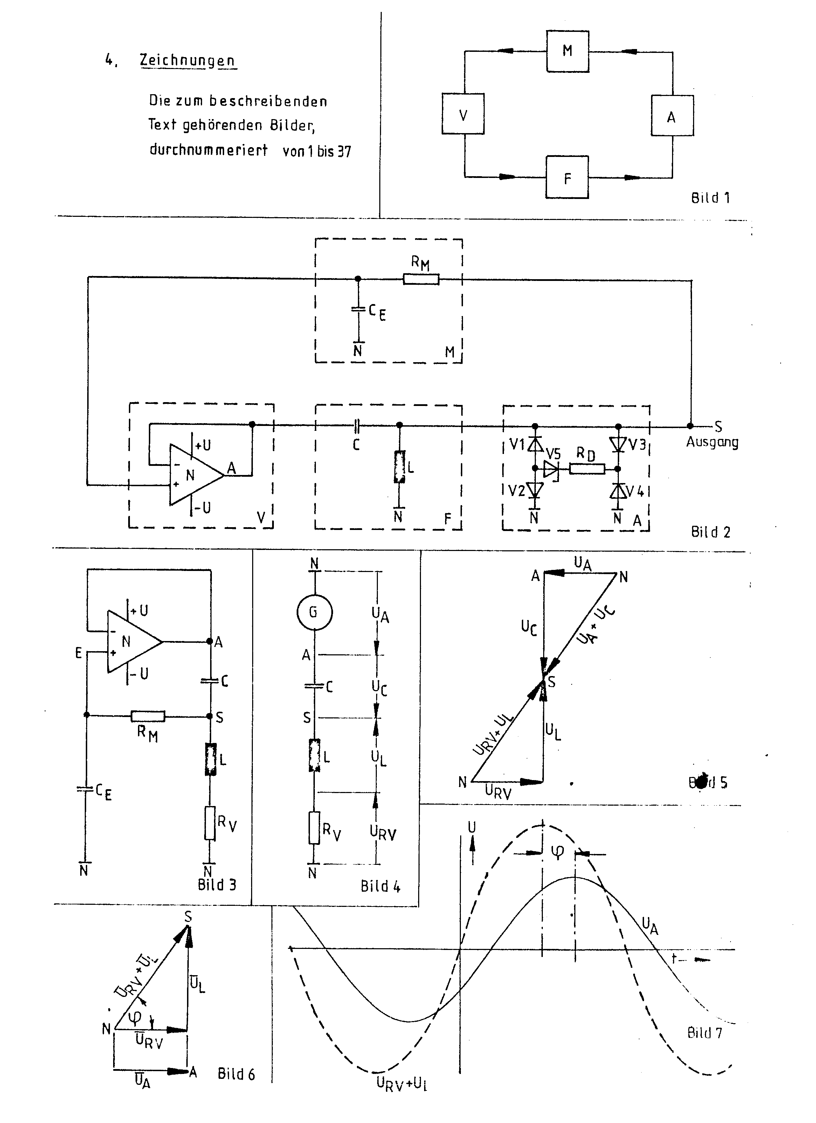

Jeder Sinusoszillator zur Erzeugung von ungedämpften elektrischen Schwingungen läßt sich in folgende Funktionseinheiten (siehe Bild 1) unterteilen:

1. Verstärker V:

   Er verstärkt das an seinem Eingang anliegende Signal, so daß dieses ausgangsseitig verstärkt zur Erregung des Schwingkreises zur Verfügung steht.

2. Frequenzbestimmendes Glied F:

   Es ist maßgebich für die Frequenz, mit der der Oszillator schwingt

3. Amplitudenbegrenzung A:

   Sie dient der Vermeidung von Verzerrungen der Schwingkreisamplitude.

4. Mitkopplungszweig M:

   Er führt die Schwingkreisausgangsspannung phasenrichtig wieder auf den Eingang des Verstärkers V zurück.

Beim Aufbau der Oszillatoren kommen in Anwendung:

1. als Verstärker V:
   - Elektronenröhren
   - Transistoren
   - Integrierte Liniarverstärker (Operationsverstärker)

2. als frequenzbestimmendes Glied F:
   - LC-Reihen- und Parallelschwingkreise
   - RC-Phasenschieberketten
   - RC-Brückenschaltungen
   - Integratoren
   - Quarze

- 3 -

0163803

3. als Amplitudenbegrenzung A:
  - Kennlinienverlauf der Elektronenröhre
  - Kennlinienverlauf des Transistors
  - Kennlinienverlauf des Verstärkers
  - Regelung des Verstärkungsfaktors
  - Regelung des Kopplungsfaktors
  - Stromgegenkopplung über den Emitterwiderstand des Oszillator-Transistors
  - Arbeitspunktverschiebung über die Gittervorspannung der Oszillator-Elektronenröhre

4. als Mitkopplungszweig M:
  - ohmsche Rückführung
  - kapazitive Rückführung
  - induktive Rückführung
  - transformatorische Rückführung

2.4   Aufbau des neuen Oszillators

Für den neuen Oszillator gilt diese Funktionseinheiten-Unterteilung ebenfalls.
Bei ihm dient (siehe Bild 2) als Verstärker V ein als nicht invertierender Verstärker geschalteter Operationsverstärker N, als frequenzbestimmendes Glied F der aus Induktivität L und Kapazität C aufgebaute Schwingkreis, als Amplitudenbegrenzung A die Diodenschaltung V1 bis V4 in Verbindung mit der Zenerdiode V5 und dem Dämpfungswiderstand $R_D$ (bei Fortfall der Amplitudenbegrenzung A ergibt sich beim neuen Oszillator eine natürliche Amplitudenbegrenzung entsprechend dem Schwingkreisdämpfungsfaktor) und als Mitkopplungszweig M der hochohmige Widerstand $R_M$ in Verbindung mit der Operationsverstärkereingangskapazität $C_E$.

Die Selbsterregung des Schwingkreises F ist nur dann gegeben, wenn durch eine genügend starke Rückkopplung die Energieverluste des Schwingkreises ständig ausgeglichen werden.
Dieser Ausgleich erfolgt über den Mitkopplungszweig M in Verbindung mit dem Verstärker V, der ein Teil der Schwingkreisspannung phasenrichtig und verstärkt so auf den Schwingkreis wieder zurückführt, daß diesem laufend die für den Verlustausgleich erforderliche Energie zur Verfügung steht.

Funktionsmäßig ist der neue Oszillator eine Reihen-Parallel-Schwingkreiskombination. Als Reihenresonanzkreis wird ihm innerhalb seines Versorgungsspannungsbereichs Energie zugeführt, die es ihm ermöglicht, als Parallelresonanzkreis weit über den Versorgungsspannungsbereich hinaus zu schwingen.

## 2.5　Funktionsweise des neuen Oszillators

Die Funktionsweise des neuen Oszillators geht aus folgendem Schaltbild (siehe Bild 3) hervor:

Die Induktivität L liegt über $R_V$ ($R_V$ ist der Verlustwiderstand der Induktivität L und Kapazität C) auf Nullpotential.
Da dem nicht invertierenden Verstärkereingang E über Induktivität L und Widerstand $R_M$ Nullpotential zugeführt wird, liegt die Kapazität C am Verstärkerausgang A gleichspannungsmäßig ebenfalls auf Nullpotential.

Durch den Einschaltvorgang selbst oder durch geringfügige Änderungen während des Betriebszustandes (z.B. Schwankungen der Betriebsspannung, Rauschen oder Belastungsänderungen) ergeben sich an der Induktivität L Spannungsschwankungen, die als Verstärkerausgangsspannung $U_A$ auf den aus Kapazität C und Induktivität L gebildeten Reihenschwingkreis zurückwirken und somit die Selbsterregung des Schwingkreises einleiten.

Wie bei den herkömmlichen Oszillatorschaltungen ist auch beim neuen Oszillatior die Rückkopplung während des gesamten Schwingvorgangs ständig im Eingriff, d.h., zur Schwingungserzeugung wird ein analoger Teil der Parallelschwingkreisspannung abgegriffen und über Mitkopplungswiderstand $R_M$ und Operationsverstärker N dem Schwingkreis erneut wieder zugeführt. Durch diese Mitkopplung, die phasen- und frequenzmäßig mit der Reihenschwingkreisspannung übereinstimmt, wird der Resonanzkreis angestoßen. Vereinfacht ausgedrückt, wird der am Verstärkerausgang A liegende Anschluß des Kondensators C im Wechsel (d.h., sinusförmig mit der Resonanzfrequenz) gegenüber Nullpotential auf die maximale positive Verstärkerausgangsspannung $+U_A$ angehoben und auf die maximale negative Verstärkerausgangsspannung $-U_A$ abgesenkt.

Da der Resonanzwiderstand des aus Kondensator C, Induktivität L und Verlustwiderstand $R_V$ gebildeten Reihenschwingkreises gleich $R_V$ ist, fließt im Resonanzfall ein Maximalstrom mit der

Amplitude:

$$I_A = \frac{U_A}{R_V}$$

der an der Induktivität L eine Resonanzspannung mit der Maximalamplitude

$$U_L = X_L \cdot I_A$$

$$= X_L \cdot \frac{U_A}{R_V}$$

und an der Kapazität C eine Resonanzspannung mit der Maximalamplitude

$$U_C = X_C \cdot I_A$$

$$= X_C \cdot \frac{U_A}{R_V}$$

zufolge hat. Hierbei ist

$$X_L = w_o \cdot L$$

die induktive und

$$X_C = \frac{1}{w_o \cdot C}$$

die kapazitive Widerstandsgröße und

$$w_o = \frac{1}{\sqrt{L \cdot C}}$$

die Kreisfrequenz.

Durch Einsetzen dieser Werte ergibt sich zwischen Parallelschwingkreisspannung $U_L$ bzw. $U_C$ und Verstärkerausgangsspannung $U_A$ das Spannungsverhältnis:

$$V_o = \frac{U_L}{U_A}$$

$$= \frac{X_L}{R_V}$$

$$= w_o \cdot L \cdot \frac{1}{R_V}$$

$$= \frac{L}{\sqrt{L \cdot C}} \cdot \frac{1}{R_V}$$

$$= \frac{1}{R_V} \cdot \sqrt{\frac{L}{C}}$$

oder

$$V_o = \frac{U_C}{U_A}$$

$$V_o = \frac{X_C}{R_V}$$

$$= \frac{1}{w_o \cdot C} \cdot \frac{1}{R_V}$$

$$= \frac{\sqrt{L \cdot C}}{C} \cdot \frac{1}{R_V}$$

$$= \frac{1}{R_V} \cdot \sqrt{\frac{L}{C}}$$

Dieses Spannungsverhältnis entspricht dem Gütefaktor q des Schwingkreises. Es ist bedeutend größer 1, d.h., die Schwingkreisspannung $U_L = U_C$ ist im Resonanzfall erheblich größer als die Verstärkerausgangsspannung $U_A$.

Zusammengefaßt gilt somit:

$$V_o = \frac{U_L}{U_A} = \frac{U_C}{U_A}$$

$$= \frac{1}{R_V} \cdot \sqrt{\frac{L}{C}}$$

$$= q \ (= \text{bedeutend größer 1})$$

## 2.6 Die vier Schwingkreisspannungen des neuen Oszillators

Die vier Schwingkreisspannungen

$\overline{U}_{RV}$ = Spannungsabfall über dem Verlustwiderstand $R_V$

$\overline{U}_L$ = Spannungsabfall über der Induktivität L

$\overline{U}_C$ = Spannungsabfall über dem Kondensator C

$\overline{U}_A$ = Verstärkerausgangsspannung

des vereinfacht dargestellten neuen Oszillators (siehe Bild 4) mit

N = Nullpotential

A = Verstärkerausgang

S = Ausgang des Parallelschwingkreises

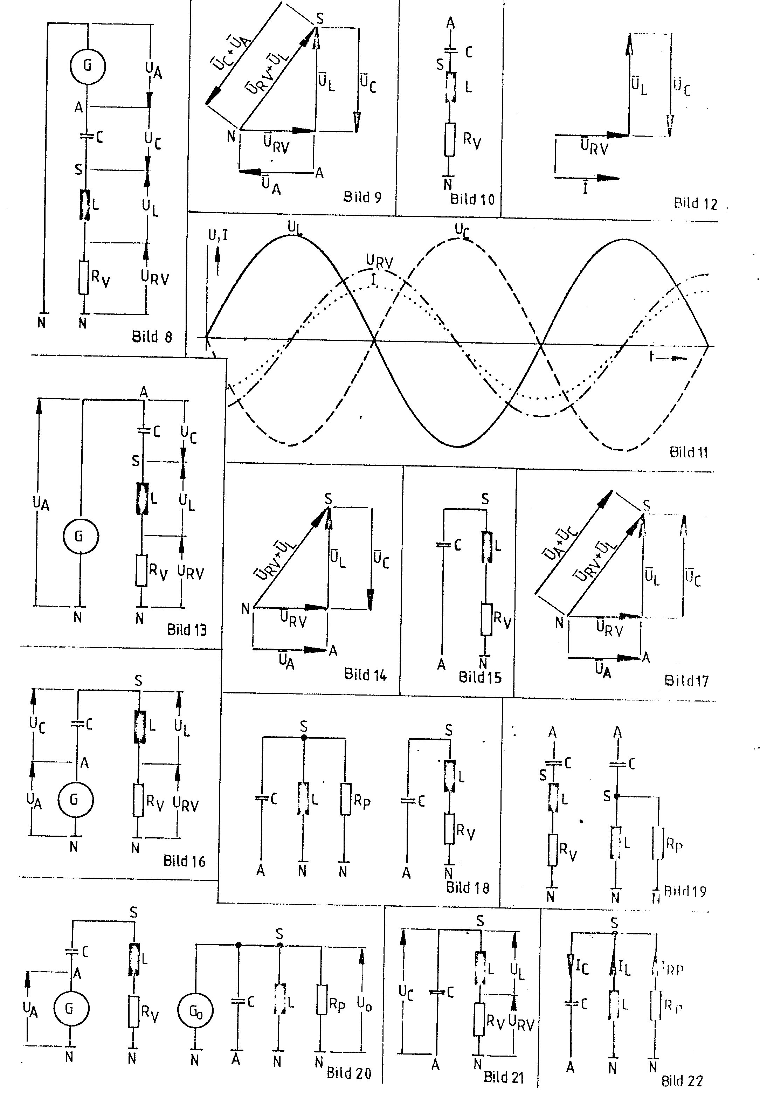

ergeben unter Berücksichtigung ihrer Phasenlage folgendes Vektordiagramm (siehe Bild 5):

Der Operationsverstärker N mit der Ausgangsspannung $U_A$ wird hier als Wechselspannungsgenerator G dargestellt.

Laut Vektordiagramm ist:

$$\overline{U}_{RV} + \overline{U}_L = -(\overline{U}_A + \overline{U}_C)$$

mit

$$\overline{U}_{RV} = - \overline{U}_A$$
$$\overline{U}_L = - \overline{U}_C$$

und

$$\overline{I}_{RV} = \overline{I}_L = \overline{I}_C = \overline{I}_A$$

$U_A$ ist hier die Generatorgröße (antreibende Kraft) und $\overline{U}_{RV} + \overline{U}_L - \overline{U}_C$ die Verbrauchergröße (angetriebene Kraft).

Die Feststellung, daß sich der Phasenwinkel $\varphi$ zwischen $U_A$ und $U_{RV} + U_L$ entsprechend dem Vektordiagramm (siehe Bild 6) verhält, wird im weiteren Verlauf der Beschreibung (siehe Kapitel 2.7 und 2.8) begründet und durch das dazugehörige Oszillogramm (siehe Bild 7) bestätigt.

Da die Induktivität L und damit der Verlustwiderstand $R_V$ auf der einen Seite und der Verstärkerausgang A und damit die Kapazität C auf der anderen Seite gleichspannungsmäßig auf Nullpotential N liegen, läßt sich das Schaltbild und Vektordiagramm des neuen Oszillators, wie folgt (siehe Bild 8 und 9), umzeichnen:

Laut Vektordiagramm ist:

$$\overline{U}_{RV} + \overline{U}_L + \overline{U}_C + \overline{U}_A = o$$

Dabei bleibt:

$$\overline{U}_{RV} = - \overline{U}_A$$
$$\overline{U}_L = - \overline{U}_C$$

und

$$\overline{I}_{RV} = \overline{I}_L = \overline{I}_C = \overline{I}_A$$

Am zweckmäßigsten läßt sich die Funktionsbeschreibung des neuen Oszillators durch eine Unterscheidung in Reihen- und Parallelschwingkreis durchführen.

In Wirklichkeit sind jedoch, wie im weiteren Verlauf das mehrfache Umzeichnen des vereinfacht dargestellten Schaltbildes des neuen Oszillators mit dem dazugehörigen Vektordiagramm der vier Schwingkreisspannungen zeigt, bei diesem Oszillator Reihen- und Parallelschwingkreis einander identische Schaltungen. Die Unterscheidung zwischen Reihen- und Parallelschwingkreis dient hier nur dem besseren Verständnis und einer vereinfachten Darstellungsweise der Funktionsbeschreibung dieses Oszillators.

## 2.7 Reihenschwingkreis-Funktion des neuen Oszillators

Der Ausgang A des Operationsverstärkers N wirkt auf den Reihenschwingkreis des neuen Oszillators, einer Reihenschaltung aus Kondensator C und Induktivität L.

Die Verluste innerhalb des Kondensators C und innerhalb der Induktivität L werden durch den Verlustwiderstand $R_V$ (siehe Bild 1o) berücksichtigt.

Da es sich bei dieser Schaltung um eine Reihenschaltung handelt, werden die drei Schaltelemente C, L und $R_V$ vom selben Strom durchflossen.

Die Spannung am Verlustwiderstand $R_V$ ist mit dem Strom in Phase, die Spannung am Kondensator C eilt gegenüber dem Strom um $9o^O$ nach und die Spannung an der Induktivität L um $9o^O$ vor. Bei Resonanz sind die beiden Spannungen, die Spannung am Kondensator C und über der Induktivität L, die beide erheblich größer als die Verstärkerausgangsspannung $U_A$ sind, gleich groß. Da sie jedoch um $18o^O$ in der Phase gegeneinander Verschoben sind, ergibt ihre Addition den Wert Null (siehe Bild 11 und 12), d.h., der Strom durch die drei Bauelemente C, L und $R_V$ nimmt im Resonanzfall seinen Maximalwert an.

Wie folgende Ableitung zeigt, ist die Größe dieses Stromes durch den Quotient aus Verstärkerausgangsspannung $U_A$ und Verlustwiderstand $R_V$ gegeben:

Aus

$$I = \frac{U_A}{R_V + j \cdot w \cdot L + \frac{1}{j \cdot w \cdot C}}$$

$$= \frac{U_A}{R_V + j \cdot (w \cdot L - \frac{1}{w \cdot C})}$$

$$= \frac{U_A}{\sqrt{R_V^2 + (\frac{1}{w \cdot C} - w \cdot L)^2}}$$

folgt mit

$$\frac{1}{w \cdot C} - w \cdot L = o$$

$$w = \frac{1}{\sqrt{L \cdot C}} = w_o$$

und

$$I = I_A$$

im Resonanzfall

$$I_A = \frac{U_A}{R_V}$$

Für den Reihenschwingkreis läßt sich das **vereinfacht dargestellte** Schaltbild des neuen Oszillators mit dem dazugehörigen Vektordiagramm der vier Schwingkreisspannungen, wie folgt (siehe Bild 13 und 14), umzeichnen:

Aus dem Vektordiagramm folgt:

$$\overline{U}_{\overline{NA}} = \overline{U}_A$$
$$\overline{U}_A = \overline{U}_{RV} + \overline{U}_L + \overline{U}_C$$

Dabei ist:

$$\overline{U}_{RV} = \overline{U}_A$$
$$\overline{U}_L = - \overline{U}_C$$

und

$$I_{RV} = I_L = I_C = - I_A$$

## 2.8    Parallelschwingkreis-Funktion des neuen Oszillators

Der Ausgang des Operationsverstärkers N bewegt sich wechselspannungsmäßig innerhalb des Versorgungsspannungsbereichs. Gleichspannungsmäßig besitzt er jedoch, wie bereits in Kapitel 2.5 beschrieben, Nullpotential (siehe Bild 15).

Damit liegt der Schwingkreis des neuen Oszillators nicht nur mit der Induktivität L über Verlustwiderstand $R_V$, sondern zusätzlich auch noch mit der Schwingkreiskapazität C über Verstärkerausgang A (niederohmig) auf Nullpotential. Er zeigt somit neben Reihenschwingkreis- auch Parallelschwingkreis-Verhalten.

Der die Induktivität L und die Kapazität C durchfließende Maximalstrom dieses Parallelschwingkreises ist identisch mit dem Reihenresonanzkreisstrom (siehe Kapitel 2.7):

$$I_A = \frac{U_A}{R_V}$$

Die an der Induktivität L bzw. an der Kapazität C bei Resonanz auftretende Maximalspannung nimmt damit folgende Werte an:

1.        $$U_L = I_A \cdot w_o \cdot L$$

oder mit $\quad w_0 = \dfrac{1}{\sqrt{L \cdot C}}$

und $\qquad I_A = \dfrac{U_A}{R_V}$

$$U_L = \dfrac{U_A}{R_V} \cdot \dfrac{L}{\sqrt{L \cdot C}}$$

$$= \dfrac{U_A}{R_V} \cdot \sqrt{\dfrac{L}{C}}$$

2. $\qquad U_C = - I_A \cdot (- \dfrac{1}{w_0 \cdot C})$

$$= \dfrac{I_A}{w_0 \cdot C}$$

oder mit $\quad w_0 = \dfrac{1}{\sqrt{L \cdot C}}$

und $\qquad I_A = \dfrac{U_A}{R_V}$

$$U_C = \dfrac{U_A}{R_V} \cdot \dfrac{\sqrt{L \cdot C}}{C}$$

$$= \dfrac{U_A}{R_V} \cdot \sqrt{\dfrac{L}{C}}$$

Die Maximalspannung über der Induktivität L stimmt also im Resonanzfall nicht nur bezüglich ihrer Amplitudengröße, sondern auch bezüglich ihres Vorzeichens mit der Maximalspannung über der Kapazität C überein (Voraussetzung beim Parallelschwingkreis).

Verallgemeinert gilt somit:

$$U_0 = U_L = U_C$$

$$= \dfrac{U_A}{R_V} \cdot \sqrt{\dfrac{L}{C}}$$

$U_0$ ist die Resonanzspannung des Parallelschwingkreises Zum gleichen Ergebnis gelangt man über die Betrachtung der in der Induktivität L und der Kapazität C wechselseitig im Resonanzfall gespeicherten Energie:

1. Die in der Induktivität gespeicherte Energie ist:

$$dA_L = N_L \cdot dt$$

$$dA_L = u_L \cdot i \cdot dt$$

oder mit $\quad u_L = L \cdot \dfrac{di}{dt}$

$$dA_L = L \cdot \dfrac{di}{dt} \cdot i \cdot dt$$

$$= L \cdot i \cdot di$$

$$A_L = L \int_0^{I_A} i \cdot di$$

$$= \dfrac{L \cdot I_A^2}{2}$$

2. Die im Kondensator gespeicherte Energie ist:

$$dA_C = N_C \cdot dt$$

$$= u \cdot i_C \cdot dt$$

oder mit $\quad i_C = C \cdot \dfrac{du}{dt}$

$$dA_C = u \cdot C \cdot \dfrac{du}{dt} \cdot dt$$

$$= C \cdot u \cdot du$$

$$A_C = C \int_0^{U_o} u \cdot du$$

$$= \dfrac{C \cdot U_o^2}{2}$$

3. Für den Resonanzfall sind beide Energiearten größenmäßig gleich

$$A_L = A_C$$

$$\dfrac{L \cdot I_A^2}{2} = \dfrac{C \cdot U_o^2}{2}$$

$$\left(\dfrac{U_o}{I_A}\right)^2 = \dfrac{L}{C}$$

$$\dfrac{U_o}{I_A} = \sqrt{\dfrac{L}{C}}$$

$$U_o = I_A \cdot \sqrt{\dfrac{L}{C}}$$

oder mit $\quad I_A = \dfrac{U_A}{R_V}$

0163803

$$U_0 = \frac{U_A}{R_V} \cdot \sqrt{\frac{L}{C}}$$

Beim neuen Oszillator ergibt sich aus dem vereinfacht dargestellten Schaltbild des Reihenschwingkreises (siehe Bild 13
und 14) das entsprechende Schaltbild des Parallelschwingkreises mit dem dazugehörigen Vektordiagramm der vier Schwingkreisspannungen, wie folgt (siehe Bild 16 und 17):

Aus dem Vektordiagramm folgt:

$$\overline{U}_{NS} = \overline{U}_{RV} + \overline{U}_L$$
$$= \overline{U}_A + \overline{U}_C$$

Dabei ist:

$$\overline{U}_{RV} = \overline{U}_A$$
$$\overline{U}_L = \overline{U}_C$$

und

$$\overline{I}_{RV} = \overline{I}_L = -\overline{I}_C = -\overline{I}_A$$

3.　　Rechnerische Abhandlung der Erfindung

Der Schwingkreis des neuen Oszillators wirkt auf den Verstärkerausgang A als Reihenresonanzkreis.

Er nimmt aufgrund seines geringen Reihenresonanzkreiswiderstands $R_V$ bereits bei einer niedrigen Verstärkerausgangsspannung $U_A$ hohe Leistung auf, so daß er als Parallelresonanzkreis mit dem Schwingkreisausgang S ungehindert, verzerrungsfrei weit über den Versorgungsspannungsbereich $^+U$ hinaus schwingt, ohne daß hierbei eine Spannungsrückwirkung auf den Verstärkerausgang besteht, d.h., der Schwingkreis des neuen Oszillators stellt funktionsmäßig eine Kombination aus Reihen- und Parallelschwingkreis dar.

Mit der folgenden Gegenüberstellung der beiden Schwingkreisarten in Kurzfassung soll das Wirkungsprinzip dieses Oszillators verdeutlicht werden:

- Beim Reihenschwingkreis (siehe Kapitel 2.7) fließt durch die Induktivität L und die Kapazität C der gleiche Reihenresonanzkreisstrom

$$I_L = I_C \, ,$$

während die Reihenresonanzkreisspannung der Induktivität L und der Kapazität C zwar in ihrer Amplitudengröße übereinstimmen, bezüglich ihres Vorzeichens jedoch entgegengesetzt gerichtet sind,

$$U_L = - U_C$$

- Beim Parallelschwingkreis (siehe Kapitel 2.8) stimmt die über der Induktivität L abfallende Resonanzspannung bezüglich Amplitudengröße und bezüglich ihres Vorzeichens mit der über der Kapazität C abfallenden Resonanzspannung überein,

$$U_L = U_C \, ,$$

während die durch die Induktivität L und die Kapazität C fließenden Resonanzströme zwar in ihrer Amplitudengröße gleich, bezüglich ihres Vorzeichens jedoch entgegengesetzt gerichtet sind,

$$I_L = - I_C$$

Da jedoch das Umzeichnen vom Reihen- in den Parallelschwingkreis beweist, daß der Schwingkreis des neuen Oszillators sowohl als Reihen-, wie auch als Parallelschwingkreis gedeutet werden kann, dient die Unterscheidung in diese beiden Schwingkreisarten nur dem besseren Verständnis dieses Oszillators.
In Wirklichkeit sind jedoch die Resonanzspannungen und -stöme
für beide Schwingkreisarten identisch.

Beim Reihenschwingkreis (Schaltung für die Leistungszufuhr)
wird für den Resonanzfall die Spannung über der Reihenschaltung aus Kapazität C und Induktivität L und beim Parallelschwingkreis (Schaltung für die Leistungsentnahme) die Spannung über der Kapazität C bzw. der Induktivität L den Betrachtungen zugrunde gelegt.

Durch die folgenden mathematischen Aufzeichnungen wird dieser
Sachverhalt bestätigt.

## 3.1 Parallelresonanzkreiswiderstand $R_P$

Damit für den Resonanzfall beim Parallelschwingkreis ein parallel zur Induktivität L und Kapazität C gedachter Parallelresonanzkreiswiderstand $R_P$ die gleiche Verlustwirkung wie der in
Reihe mit der Induktivität L liegende Verlustwiderstand $R_V$
zeigt (siehe Bild 18) muß dieser Widerstand folgende Größe besitzen:

Aus

$$\frac{1}{R_P} + \frac{1}{j \cdot w \cdot L} + j \cdot w \cdot C = \frac{1}{R_V + j \cdot w \cdot L} + j \cdot w \cdot C$$

$$\frac{1}{R_P} - j \frac{1}{w \cdot L} = \frac{1}{R_V + j \cdot w \cdot L}$$

$$\frac{R_V + j \cdot w \cdot L}{R_P} - j \frac{R_V + j \cdot w \cdot L}{w \cdot L} = 1$$

$$\frac{R_V}{R_P} + j \frac{w \cdot L}{R_P} - j \frac{R_V}{w \cdot L} + 1 = 1$$

$$\frac{R_V}{R_P} + j \left( \frac{w \cdot L}{R_P} - \frac{R_V}{w \cdot L} \right) = 0$$

folgt für den Resonanzfall

$$j \left( \frac{w \cdot L}{R_P} - \frac{R_V}{w \cdot L} \right) = 0$$

$$\frac{w \cdot L}{R_V} = \frac{R_V}{w \cdot L}$$

$$w^2 \cdot L^2 = R_V \cdot R_P$$

$$R_P = \frac{1}{R_V} w^2 \cdot L^2$$

oder mit

$$w = \frac{1}{\sqrt{L \cdot C}} = w_o$$

schließlich

$$R_P = \frac{1}{R_V} \cdot \frac{L^2}{L \cdot C}$$

$$= \frac{1}{R_V} \cdot \frac{L}{C}$$

und

$$R_V = \frac{1}{R_P} \cdot \frac{L}{C}$$

Das gleiche Ergebnis ergibt sich für den Reihenschwingkreis (siehe Bild 19) im Resonanzfall:

Aus

$$R_V + j \cdot w \cdot L + \frac{1}{j \cdot w \cdot C} = \frac{1}{\frac{1}{R_P} + \frac{1}{j \cdot w \cdot L}} + \frac{1}{j \cdot w \cdot C}$$

$$R_V + j \cdot w \cdot L = \frac{1}{\frac{1}{R_P} + \frac{1}{j \cdot w \cdot L}}$$

$$(\frac{1}{R_P} - j \frac{1}{w \cdot L}) (R_V + j \cdot w \cdot L) = 1$$

$$\frac{R_V}{R_P} + j \frac{w \cdot L}{R_P} - j \frac{R_V}{w \cdot L} + 1 = 1$$

$$\frac{R_V}{R_P} + j (\frac{w \cdot L}{R_P} - \frac{R_V}{w \cdot L}) = o$$

folgt für den Resonanzfall

$$j (\frac{w \cdot L}{R_P} - \frac{R_V}{w \cdot L}) = o$$

und damit ebenfalls

$$R_P = \frac{1}{R_V} \cdot \frac{L}{C}$$

und

$$R_V = \frac{1}{R_P} \cdot \frac{L}{C}$$

3.2 Zusammenhang zwischen der Resonanzspannung $U_o$ und der Verstärkerausgangsspannung $U_A$ beim neuen Oszillator Da $R_V$ und $R_P$, wie bewiesen, im Resonanzfall gleiches Verlustwirkungsverhalten zeigen, kann die Resonanzspannung $U_o$ auch über die Verlustleistung $N_A$ des Reihen- und die Verlustleistung $N_o$ des Parallelresonanzkreises (siehe Bild 2o) ermittelt werden:

Aus

$$N_A = N_o$$

$$U_A \cdot I_A = U_o \cdot I_o$$

$$U_A \cdot \frac{U_A}{R_V} = U_o \cdot \frac{U_o}{R_P}$$

$$\frac{U_A^2}{R_V} = \frac{U_o^2}{R_P}$$

$$U_o^2 = U_A^2 \cdot \frac{R_P}{R_V}$$

$$U_o = U_A \cdot \sqrt{\frac{R_P}{R_V}}$$

folgt mit

$$R_P = \frac{1}{R_V} \cdot \frac{L}{C}$$

die Größe

$$U_o = U_A \sqrt{\frac{1}{R_V^2} \cdot \frac{L}{C}}$$

$$= \frac{U_A}{R_V} \sqrt{\frac{L}{C}}$$

oder mit

$$R_V = \frac{1}{R_P} \cdot \frac{L}{C}$$

entsprechend

$$U_o = U_A \sqrt{R_P^2 \cdot \frac{C}{L}}$$

$$= U_A \cdot R_P \sqrt{\frac{C}{L}}$$

## 3.3 Dämpfungsfaktor d des Schwingkreises

Für den Reihen- und Parallelresonanzkreis ergeben sich unterschiedliche Dämpfungsfaktoren, die jedoch über die Widerstandsumrechnungsformel

$$R_V = \frac{1}{R_P} \cdot \frac{L}{C}$$

miteinander in Verbindung stehen.

1. Der Dämpfungsfaktor d des Reihenresonanzkreises (siehe Bild 21) folgt entweder aus dem Spannungsverhältnis:

$$d = \frac{U_{RV}}{U_L}$$

$$= \frac{I_A \cdot R_V}{I_A \cdot w_o \cdot L}$$

$$= \frac{R_V}{w_o \cdot L}$$

$$= \frac{R_V}{L} \cdot \sqrt{L \cdot C}$$

$$= R_V \cdot \sqrt{\frac{C}{L}}$$

oder aus dem Spannungsverhältnis:

$$d = \frac{U_{RV}}{U_C}$$

$$= \frac{I_A \cdot R_V}{I_A \cdot \dfrac{1}{w_o \cdot C}}$$

$$= R_V \cdot w_o \cdot C$$

$$= R_V \cdot \frac{C}{\sqrt{L \cdot C}}$$

$$= R_V \cdot \sqrt{\frac{C}{L}}$$

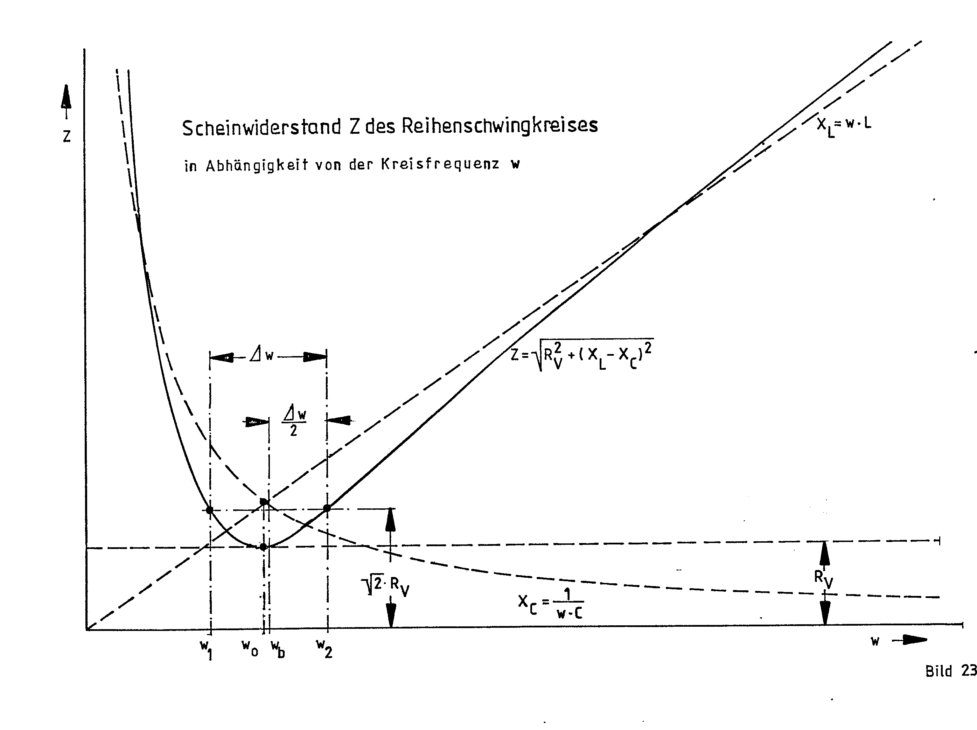

2. Der Dämpfungsfaktor d des Parallelresonanzkreises (siehe Bild 22) folgt entweder aus dem Stromverhältnis:

$$d = \frac{I_{RP}}{I_L}$$

$$= \frac{U_o}{R_P} \cdot \frac{w_o \cdot L}{U_o}$$

$$= \frac{w_o \cdot L}{R_P}$$

$$= \frac{L}{\sqrt{L \cdot C}} \cdot \frac{1}{R_P}$$

$$= \frac{1}{R_P} \cdot \sqrt{\frac{L}{C}}$$

oder aus dem Stromverhältnis

$$d = \frac{I_{RP}}{I_C}$$

$$= \frac{U_o}{R_P} \cdot \frac{1}{U_o \cdot w_o \cdot C}$$

$$= \frac{1}{R_P} \cdot \frac{\sqrt{L \cdot C}}{C}$$

$$= \frac{1}{R_P} \cdot \sqrt{\frac{L}{C}}$$

3. Mit

$$\frac{1}{R_P} = R_V \cdot \frac{C}{L}$$

folgt aus

$$d = \frac{1}{R_P} \cdot \sqrt{\frac{L}{C}}$$

die Gleichung

$$d = R_V \cdot \frac{C}{L} \cdot \sqrt{\frac{L}{C}}$$

$$= R_V \cdot \sqrt{\frac{C}{L}}$$

und mit

$$R_V = \frac{1}{R_P} \cdot \frac{L}{C}$$

aus

$$d = R_V \cdot \sqrt{\frac{C}{L}}$$

wiederum die Gleichung

$$d = \frac{1}{R_P} \cdot \frac{L}{C} \cdot \sqrt{\frac{C}{L}}$$

$$= \frac{1}{R_P} \cdot \sqrt{\frac{L}{C}}$$

## 3.4  Gütefaktor q des Schwingkreises

Der Gütefaktor q des Schwingkreises entspricht seinem reziproken Dämpfungsfaktor d.

Für den Reihen- und Parallelschwingkreis ergeben sich unterschiedliche Gütefaktoren, die jedoch über die Widerstandsumrechnungsformel

$$R_V = \frac{1}{R_P} \cdot \frac{L}{C}$$

miteinander in Verbindung stehen.

Der Gütefaktor ist beim Reihenresonanzkreis

$$q = \frac{1}{d}$$

$$= \frac{1}{R_V} \cdot \sqrt{\frac{L}{C}}$$

und beim Parallelresonanzkreis

$$q = \frac{1}{d}$$

$$= R_P \cdot \sqrt{\frac{C}{L}}$$

Die Gleichung für die Resonanzspannung (siehe Kapitel 3.2)

$$U_o = \frac{U_A}{R_V} \cdot \sqrt{\frac{L}{C}}$$

und

$$U_o = U_A \cdot R_P \cdot \sqrt{\frac{C}{L}}$$

vereinfacht sich mit

$$q = \frac{1}{R_V} \cdot \sqrt{\frac{L}{C}}$$

und

$$q = R_P \cdot \sqrt{\frac{C}{L}}$$

zu

$$U_o = q \cdot U_A$$

$$= \frac{1}{d} \cdot U_A$$

Beim neuen Oszillator treten keine Verzerrungen auf, da eine Begrenzung der Schwingkreisamplitude durch den Verstärker nicht erfolgt.

Beim Fehlen einer Amplitudenbegrenzung ergibt sich für diesen Oszillator eine natürliche Begrenzung der Schwingkreisamplitude, die vom Güte- bzw. Dämpfungsfaktor des Schwingkreises abhängig ist.

3.5  Kreisfrequenzdifferenz $\Delta$ w der Bandbreite beim Reihen-schwingkreis

Die Kreisfrequenzdifferenz $\Delta$ w der Bandbreite errechnet sich beim Reihenschwingkreis (siehe Bild 23) aus der Differenz der Kreisfrequenz $w_2$ oberhalb der Resonanzkreisfrequenz $w_o$, für

die der induktive Blindwiderstand $(X_L - X_C)_{w2}$ gleich dem Verlustwiderstand $R_V$ ist, und der Kreisfrequenz $w_1$ unterhalb der Resonanzkreisfrequenz $w_o$, für die der jetzt kapazitive Blindwiderstand $(X_C - X_L)_{w1}$ ebenfalls die Verlustwiderstandsgröße $R_V$ erreicht.

Für beide Kreisfrequenzen $w_2$ und $w_1$ ist damit der jeweilige Scheinwiderstand

$$Z_{w2} = \sqrt{R_V^2 + (X_L - X_C)_{w2}^2}$$
$$= \sqrt{R_V^2 + R_V^2}$$
$$= \sqrt{2} \cdot R_V$$

und

$$Z_{w1} = \sqrt{R_V^2 + (X_C - X_L)_{w1}^2}$$
$$= \sqrt{R_V^2 + R_V^2}$$
$$= \sqrt{2} \cdot R_V$$

gleich groß.

Der $\triangle$ w-Wert folgt aus der Differenz der beiden Kreifrequenzen $w_2$ und $w_1$:

1. Kreisfrequenz $w_2$ oberhalb der Resonanzkreisfrequenz $w_o$, für die der induktive Blindwiderstand

$$(X_L - X_C)_{w2} = w_2 \cdot L - \frac{1}{w_2 \cdot C}$$

die Verlustwiderstandsgröße $R_V$ erreicht:

$$R_V = w_2 \cdot L - \frac{1}{w_2 \cdot C}$$

$$w_2 \cdot R_V = w_2^2 \cdot L - \frac{1}{C}$$

$$w_2 \cdot \frac{R_V}{L} = w_2^2 - \frac{1}{L \cdot C}$$

$$w_2^2 - \frac{R_V}{L} \cdot w_2 = \frac{1}{L \cdot C}$$

$$\left(w_2 - \frac{R_V}{2 \cdot L}\right)^2 = \frac{R_V^2}{4 \cdot L^2} + \frac{1}{L \cdot C}$$

$$w_2 = \frac{R_V}{2 \cdot L} + \sqrt{\frac{R_V^2}{4 \cdot L^2} + \frac{1}{L \cdot C}}$$

0163803

2. Kreisfrequenz $w_1$ unterhalb der Resonanzkreisfrequenz $w_o$, für die der jetzt kapazitive Blindwiderstand

$$(X_C - X_L)_{w1} = \frac{1}{w_1 \cdot C} - w_1 \cdot L$$

die Verlustwiderstandsgröße $R_V$ erreicht:

$$R_V = \frac{1}{w_1 \cdot C} - w_1 \cdot L$$

$$w_1 \cdot R_V = \frac{1}{C} - w_1^2 \cdot L$$

$$w_1 \cdot \frac{R_V}{L} = \frac{1}{L \cdot C} - w_1^2$$

$$w_1^2 + \frac{R_V}{L} \cdot w_1 = \frac{1}{L \cdot C}$$

$$(w_1 + \frac{R_V}{2 \cdot L})^2 = \frac{R_V^2}{4 \cdot L^2} + \frac{1}{L \cdot C}$$

$$w_1 = - \frac{R_V}{2 \cdot L} + \sqrt{\frac{R_V^2}{4 \cdot L^2} + \frac{1}{L \cdot C}}$$

3. Kreisfrequenzdifferenz $\triangle$ w der Bandbreite beim Reihenschwingkreis

$$\triangle w = w_2 - w_1$$

$$= \frac{R_V}{2 \cdot L} + \sqrt{\frac{R_V^2}{4 \cdot L^2} + \frac{1}{L \cdot C}}$$

$$+ \frac{R_V}{2 \cdot L} - \sqrt{\frac{R_V^2}{4 \cdot L^2} + \frac{1}{L \cdot C}}$$

$$= \frac{R_V}{L}$$

3.6   Kreisfrequenzdifferenz $\triangle$ w der Bandbreite beim Parallelschwingkreis

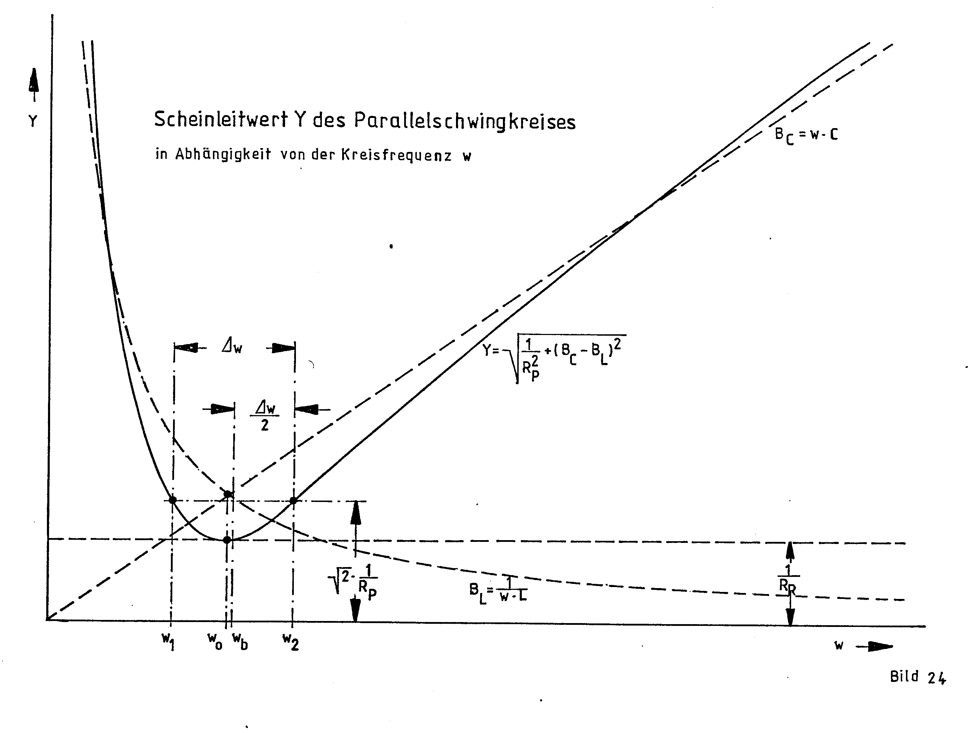

Die Kreisfrequenzdifferenz $\triangle$ w der Bandbreite errechnet sich beim Parallelschwingkreis(siehe Bild 24) aus der Differenz der Kreisfrequenz $w_2$ oberhalb der Resonanzkreisfrequenz $w_o$, für die der kapazitive Blindleitwert $(B_C - B_L)_{w2}$ gleich dem Verlustleitwert $1/R_P$ ist, und der Kreisfrequenz $w_1$ unterhalb der Resonanzkreisfrequenz $w_o$, für die der jetzt induktive Blindleitwert $(B_L - B_C)_{w1}$ ebenfalls die Verlustleitwertgröße $1/R_P$ erreicht.

Für beide Kreisfrequenzen $w_2$ und $w_1$ ist damit der jeweilige Scheinleitwert

$$Y_{w2} = \sqrt{\frac{1}{R_P^2} + (B_C - B_L)_{w2}^2}$$

$$= \sqrt{\frac{1}{R_P^2} + \frac{1}{R_P^2}}$$

$$= \sqrt{2} \cdot \frac{1}{R_P}$$

und

$$Y_{w1} = \sqrt{\frac{1}{R_P^2} + (B_L - B_C)_{w1}^2}$$

$$= \sqrt{\frac{1}{R_P^2} + \frac{1}{R_P^2}}$$

$$= \sqrt{2} \cdot \frac{1}{R_P}$$

gleich groß.

Der $\triangle$ w-Wert folgt wieder aus der Differenz der beiden Kreisfrequenzen $w_2$ und $w_1$:

1. Kreisfrequenz $w_2$ oberhalb der Resonanzkreisfrequenz $w_o$, für die der kapazitive Blindleitwert

$$(B_C - B_L)_{w2} = w_2 \cdot C - \frac{1}{w_2 \cdot L}$$

die Verlustleitwertgröße $1/R_P$ erreicht:

$$\frac{1}{R_P} = w_2 \cdot C - \frac{1}{w_2 \cdot L}$$

$$w_2 \cdot \frac{1}{R_P} = w_2^2 \cdot C - \frac{1}{L}$$

$$w_2 \cdot \frac{1}{R_P \cdot C} = w_2^2 - \frac{1}{L \cdot C}$$

$$(w_2 - \frac{1}{2 \cdot R_P \cdot C})^2 = \frac{1}{4 \cdot R_P^2 \cdot C^2} + \frac{1}{L \cdot C}$$

$$w_2 = \frac{1}{2 \cdot R_P \cdot C} + \sqrt{\frac{1}{4 \cdot R_P^2 \cdot C^2} + \frac{1}{L \cdot C}}$$

2. Kreisfrequenz $w_1$ unterhalb der Resonanzkreisfrequenz $w_o$, für die der jetzt induktive Blindleitwert

$$(B_L - B_C)_{w1} = \frac{1}{w_1 \cdot L} - w_1 \cdot C$$

0163803

die Verlustleistung $1/R_P$ erreicht:

$$\frac{1}{R_P} = \frac{1}{w_1 \cdot L} - w_1 \cdot C$$

$$w_1 \cdot \frac{1}{R_P} = \frac{1}{L} - w_1^2 \cdot C$$

$$w_1 \cdot \frac{1}{R_P \cdot C} = \frac{1}{L \cdot C} - w_1^2$$

$$w_1^2 + w_1 \cdot \frac{1}{R_P \cdot C} = \frac{1}{L \cdot C}$$

$$\left(w_1 + \frac{1}{2 \cdot R_P \cdot C}\right)^2 = \frac{1}{4 \cdot R_P^2 \cdot C^2} + \frac{1}{L \cdot C}$$

$$w_1 = - \frac{1}{2 \cdot R_P \cdot C} + \sqrt{\frac{1}{4 \cdot R_P^2 \cdot C^2} + \frac{1}{L \cdot C}}$$

3. Kreisfrequenzdifferenz $\triangle$ w der Bandbreite beim Parallel-schwingkreis

$$\triangle w = w_2 - w_1$$

$$= \frac{1}{2 \cdot R_P \cdot C} + \sqrt{\frac{1}{4 \cdot R_P^2 \cdot C^2} + \frac{1}{L \cdot C}}$$

$$+ \frac{1}{2 \cdot R_P \cdot C} - \sqrt{\frac{1}{4 \cdot R_P^2 \cdot C^2} + \frac{1}{L \cdot C}}$$

$$= \frac{1}{R_P \cdot C}$$

Hieraus folgt mit der Widerstandsumrechnungsformel

$$R_P = \frac{1}{R_V} \cdot \frac{L}{C}$$

der $\triangle$ w-Wert für den Reihenschwingkreis, wie bekannt:

$$\triangle w = R_V \cdot \frac{C}{L} \cdot \frac{1}{C}$$

$$= \frac{R_V}{L}$$

3.7 Mittlere Kreisfrequenz $w_b$ der Bandbreite

Wie aus den Gleichungen

$$w_{1,2} = \frac{-}{+} \frac{R_V}{2 \cdot L} + \sqrt{\frac{R_V^2}{4 \cdot L^2} + \frac{1}{L \cdot C}}$$

und

$$w_{1,2} = \mp \frac{1}{2 \cdot R_P \cdot C} + \sqrt{\frac{1}{4 \cdot R_P^2 \cdot C^2} + \frac{1}{L \cdot C}}$$

(siehe Kapitel 3.5 und 3.6) hervorgeht, ist die mittlere Kreisfrequenz der Bandbreite

$$w_b = \sqrt{\frac{R_V^2}{4 \cdot L^2} + \frac{1}{L \cdot C}}$$

oder

$$w_b = \sqrt{\frac{1}{4 \cdot R_P^2 \cdot C^2} + \frac{1}{L \cdot C}}$$

um den Wert

$$\Delta w_{bo} = w_b - w_o$$

$$= \sqrt{\frac{R_V^2}{4 \cdot L^2} + \frac{1}{L \cdot C}} - \frac{1}{\sqrt{L \cdot C}}$$

$$= \frac{1}{\sqrt{L \cdot C}} \cdot \left( \sqrt{\frac{R_V^2 \cdot C}{4 \cdot L} + 1} - 1 \right)$$

$$= w_o \cdot \left( \sqrt{\frac{1}{4 \cdot q^2} + 1} - 1 \right)$$

oder

$$\Delta w_{bo} = \sqrt{\frac{1}{4 \cdot R_P^2 \cdot C^2} + \frac{1}{L \cdot C}} - \frac{1}{\sqrt{L \cdot C}}$$

$$= \frac{1}{\sqrt{L \cdot C}} \cdot \left( \sqrt{\frac{L}{4 \cdot R_P^2 \cdot C} + 1} - 1 \right)$$

$$= w_o \cdot \left( \sqrt{\frac{1}{4 \cdot q^2} + 1} - 1 \right)$$

größer als die Kreisfrequenz $w_o$, d.h., die Kreisfrequenzdifferenz $\Delta w_{bo}$, die Differenz zwischen der Resonanzkreisfrequenz $w_o$ und der mittleren Kreisfrequenz der Bandbreite $w_b$, läßt sich durch Multiplikation der Kreisfrequenz $w_o$ mit dem Faktor

$$k = \sqrt{\frac{1}{4 \cdot q^2} + 1} - 1$$

bestimmen:

$$\Delta w_{bo} = k \cdot w_o$$

3.8    Bandbreite b, Dämpfungsfaktor d und Gütefaktor q des
       Schwingkreises, mit Hife des $\triangle$ w-Wertes definiert

Da sich der $\triangle$ w-Wert des Reihenschwingkreises über die Widerstandsumrechnungsformel

$$R_P = \frac{1}{R_V} \cdot \frac{L}{C}$$

in den $\triangle$ w-Wert des Parallelschwingkreises umrechnen läßt, kommt im Folgenden für die Berechnung der Bandbreite und des Dämpfungs- und Gütefaktors nur der für den Reihenschwingkreis errechnete $\triangle$ w-Wert in Anwendung.

Die Größe des $\triangle$ w-Wertes läßt sich meßtechnisch mit Hilfe eines Sinus-Generators und eines Oszilloskops ermitteln.

Mit dem $\triangle$ w-Wert des Reihenschwingkreises

$$\triangle w = \frac{R_V}{L}$$

ergibt sich demnach:

1. Bandbreite b

$$b = f_2 - f_1$$

$$= \frac{1}{3,14} (w_2 - w_1)$$

$$= \frac{1}{3,14} \cdot \triangle w$$

$$= \frac{1}{3,14} \cdot \frac{R_V}{L}$$

2. Dämpfungsfaktor d (relative Bandbreite)

$$d = \frac{f_2 - f_1}{f_o}$$

$$= \frac{w_2 - w_1}{w_o}$$

$$= \frac{\triangle w}{w_o}$$

$$= \frac{R_V}{L} \cdot \sqrt{L \cdot C}$$

$$= R_V \cdot \sqrt{\frac{C}{L}}$$

3. Gütefaktor q (Resonanzschärfe oder Resonanzüberhöhung)

$$q = \frac{f_o}{f_2 - f_1}$$

$$= \frac{w_o}{\Delta w}$$

$$= \frac{L}{R_V} \cdot \frac{1}{\sqrt{L \cdot C}}$$

$$= \frac{1}{R_V} \cdot \sqrt{\frac{L}{C}}$$

## 3.9 Mitkopplungswiderstand $R_M$ des neuen Oszillators

Der Mitkopplungszweig M des neuen Oszillators führt über einen hochohmigen Mitkopplungswiderstand $R_M$ die Ausgangsspannung $U_o + U_{RV}$ des Parallelschwingkreises auf den nicht invertierenden Eingang des Operationsverstärkers N zurück (siehe Bild 2).

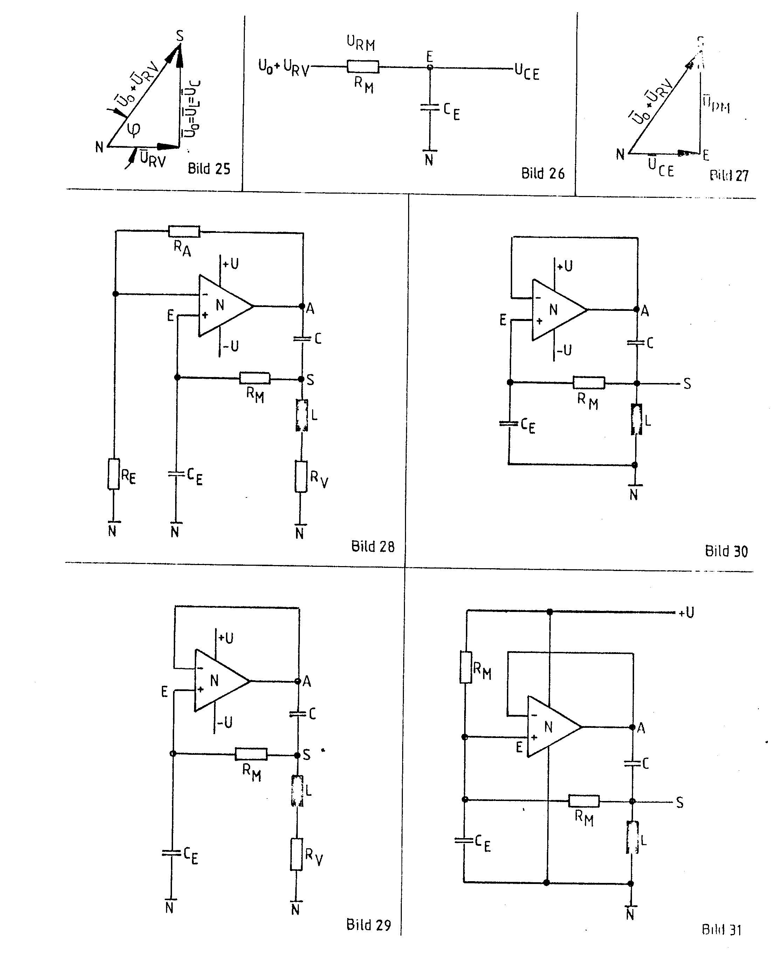

Da diese Spannung gegenüber $U_{RV}$, dem Spannungsabfall über dem Verlustwiderstand $R_V$, um den Phasenwinkel $\varphi < 9o^o$ voreilt, muß (siehe Bild 25), damit Eingangs- und Ausgangsspannung des Verstärkers wieder übereinstimmen, eine Korrektur dieser Phasenverschiebung vorgenommen werden.

Dieses wird durch den hochohmigen Mitkopplungswiderstand $R_M$ in Verbindung mit der Operationsverstärker-Eingangskapazität $C_E$ (siehe Bild 26), die alle zwischen Schwingkreisausgang S und Verstärkerausgang A befindlichen kapazitiven Größen des Rückführungszweigs beinhaltet, erreicht.

Das dazugehörige Vektordiagramm dieses RC-Glieds (siehe Bild 27) entspricht größenmäßig dem Vektordiagramm für die Ausgangsspannung des Parallelschwingkreises (siehe Bild 25).
Der Operationsverstärker-Eingangswiderstand wurde hierbei als unendlich groß angenommen (was den tatsächlichen Verhältnissen sehr nahe kommt - hochohmiger Widerstand des nicht invertierenden Operationsverstärker-Eingangs) und in die Überlegungen nicht einbezogen.

Ein Vergleich der beiden Vektordiagramme führt mit

$$U_{RM} = U_o$$

und

$$U_{CE} = U_{RV} = U_A$$

zu der Proportion

$$\frac{U_o}{U_{RV}} = \frac{U_{RM}}{U_{CE}} \ ,$$

aus der sich die Größe des Mittkopplungswiderstandes $R_M$, wie

- 27 -                    0163803

folgt, bestimmen läßt:

1.
$$\frac{w_o \cdot L \cdot I_A}{R_V \cdot I_A} = \frac{R_M \cdot I_E}{\frac{1}{w_o \cdot C_E} \cdot I_E}$$

$$\frac{w_o \cdot L}{R_V} = R_M \cdot w_o \cdot C_E$$

$$R_M \lessgtr \frac{L}{R_V \cdot C_E}$$

2.
$$\frac{\frac{1}{w_o \cdot C} \cdot I_A}{R_V \cdot I_A} = \frac{R_M \cdot I_E}{\frac{1}{w_o \cdot C_E} \cdot I_E}$$

$$\frac{1}{w_o \cdot C \cdot R_V} = R_M \cdot w_o \cdot C_E$$

$$R_M \lessgtr \frac{1}{w_o^2 \cdot C \cdot R_V \cdot C_E}$$

$$\lessgtr \frac{L \cdot C}{C \cdot R_V \cdot C_E}$$

$$\lessgtr \frac{L}{R_V \cdot C_E}$$

Das Ergebnis zeigt, daß die Größe des Mitkopplungswiderstand $R_M$ frequenzunabhängig ist. Da zudem aus Gleichung

$$U_o = q \cdot U_A$$

$$= \frac{U_o}{U_A} \cdot U_{CE}$$

$$= \frac{w_o \cdot L \cdot I_A}{R_V \cdot I_A} \cdot U_{CE}$$

$$= \frac{w_o \cdot L}{R_V} \cdot \frac{1}{w_o \cdot C_E} \cdot I_E$$

hervorgeht, daß der Gütefaktor

$$q = \frac{w_o \cdot L}{R_V}$$

des Schwingkreises bei Verkleinern der Schwingkreiskapazität C und damit steigender Kreisfrequenz $w_o$ in gleichem Maße zunimmt, wie der Spannungsabfall

$$U_{CE} = \frac{1}{w_o \cdot C_E} \cdot I_E$$

über der Eingangskapazität $C_E$ und damit die Ausgangsspannung $U_A$ des Verstärkers abfällt, bleibt die Schwingkreisspannung $U_O$ frequenzunabhängig annähernd konstant, zumal der Eingangsstrom $I_E$, von

$$R_M \gg \frac{1}{w_O \cdot C_E}$$

geprägt, ebenfalls weitgehend frequenzunabhängig ist:

$$U_O = \frac{w_O \cdot L}{R_V} \cdot \frac{1}{w_O \cdot C_E} \cdot I_E$$

$$= R_M \cdot I_E$$

Bei einer Vergrößerung der Verstärkereingangskapazität $C_E$ durch einen zwischen Verstärkereingang und Nullpotential geschalteten zusätzlichen Kondensator $C_Z$ ergibt sich für

$$R_M = \frac{L}{R_V \cdot (C_E + C_Z)}$$

ein geringerer Widerstandswert.

Im Hinblick auf eine möglichst geringe Schwingkreisdämpfung ist jedoch von einer Vergrößerung der Verstärkereingangskapazität $C_E$ durch Parallelschalten eines Kondensators $C_Z$ Abstand zu nehmen, da diese Zusatzkapazität in Verbindung mit dem dazugehörigen, geringeren Widerstandswert $R_M$ eine unnötige zusätzliche Schwingkreisbelastung darstellt.

3.1o  Kreisverstärkung $V_O \cdot K_O$ des neuen Oszillators

Der Verstärker V des neuen Oszillators ist ein als Spannungsfolger geschalteter Operationsverstärker N.
An seinem hochohmigen, nicht invertierenden Eingang liegt die Eingangsspannung $U_{CE}$, die bei einer Spannungsverstärkung $V = 1$ am Ausgang A leistungsverstärkt, in gleicher Größe als Verstärkerausgangsspannung $U_A$ zur Verfügung steht und den Verstärkerausgangsstrom

$$I_A = \frac{U_A}{R_V}$$

durch den Reihenschwingkreis aus Kapazität C, Induktivität L und Verlustwiderstand $R_V$ treibt.
Die Ausgangsspannung des Parallelschwingkreises $U_O + U_{RV}$, die angenähert um den Gütefaktor q des Schwingkreises größer als die Verstärkerausgangsspannung $U_A$ ist, wird über den Mitkopplungswiderstand $R_M$ dem Verstärkereingang direkt zugeführt, so daß der Verstärker selbst keine Spannungs-, sondern lediglich eine Leistungsverstärkung zu erbringen hat.

Der Verstärkungsfaktor des neuen Oszillators

$$V_O = V \cdot q$$

ergibt für den Verstärkungsfaktor des nicht invertierenden Operationsverstärkers N (siehe Bild 28),

$$V = \frac{U_A}{U_E}$$

$$= \frac{R_A + R_E}{R_E}$$

$$= 1 + \frac{R_A}{R_E} \,,$$

der für $R_A = o$ (siehe Bild 29) in $V = 1$ übergeht (dabei entfällt $R_E$), und für den Gütefaktor des Schwingkreises

$$q = \frac{U_O}{U_A}$$

den Wert

$$V_O = \frac{U_O}{U_A}$$

Da die Kreisverstärkung des Oszillators, das Produkt aus Verstärkungsfaktor $V_O$ und Rückkopplungsfaktor $K_O$, zur Aufrechterhaltung der Schwingungen (d.h., zur Deckung der Schwingkreiverluste) jedoch gleich oder größer 1 sein muß,

$$V_O \cdot K_O \gtreqqless 1 \,,$$

darf bei Einhaltung dieser Forderung der Kopplungsfaktor $K_O$ des neuen Oszillators nicht kleiner als der reziproke Wert von $V_O$ sein:

$$K_O \gtreqqless \frac{1}{V_O}$$

$$\gtreqqless \frac{U_A}{U_O}$$

Mit diesem Wert wird die Forderung, daß

$$V_O \cdot K_O = \frac{U_O}{U_A} \cdot (\gtreqqless \frac{U_A}{U_O})$$

$$\gtreqqless \frac{U_O}{U_A} \cdot \frac{U_A}{U_O}$$

$\geqq 1$

sein muß, erfüllt.

3.11 Frequenzverhalten des neuen Oszillators

Die mit dem neuen Oszillator maximal erreichbare Frequenz ist neben dem gewählten Aufbau (Anordnung der elektronischen Bauelemente des Oszillators) unter anderem abhängig:

- von der Größe der gewählten Induktivität L des Schwingkreises F

- von der der Induktivität L anhaftenden Kapazität $C_L$ (Spulenkapazität, verursacht durch die nebeneinander angeordneten Windungen)

- vom Frequenzverhalten der Amplitudenbegrenzung A, sofern vorhanden

- vom Frequenzverhalten des Mitkopplungszweiges M, des RC-Glieds aus Mitkopplungswiderstand $R_M$ und Operationsverstärker-Eingangskapazität $C_E$

- vom Frequenzverhalten des Verstärkers V (Operationsverstärker N, gegebenenfalls mit Gegentaktendstufe), dem dynamischen Verhalten des Verstärkers in Abhängigkeit von der Frequenz

- von der Schwingkreisbelastung durch angeschlossene Verbraucher (beim Abgreifen der Schwingkreisspannung zu ihrer Nutzung und Weiterverarbeitung)

3.12 Versorgungsgleichspannungen $^+_-U$ bzw. Versorgungsgleichspannung +U des neuen Oszillators

Zum Betreiben des neuen Oszillators in der beschriebenen Form werden zwei gleich große Versorgungsgleichspannungen, vom Nullpotential N des Netzteils aus gesehen eine positive und eine negative Spannung, +U und -U, (siehe Bild 30) benötigt.

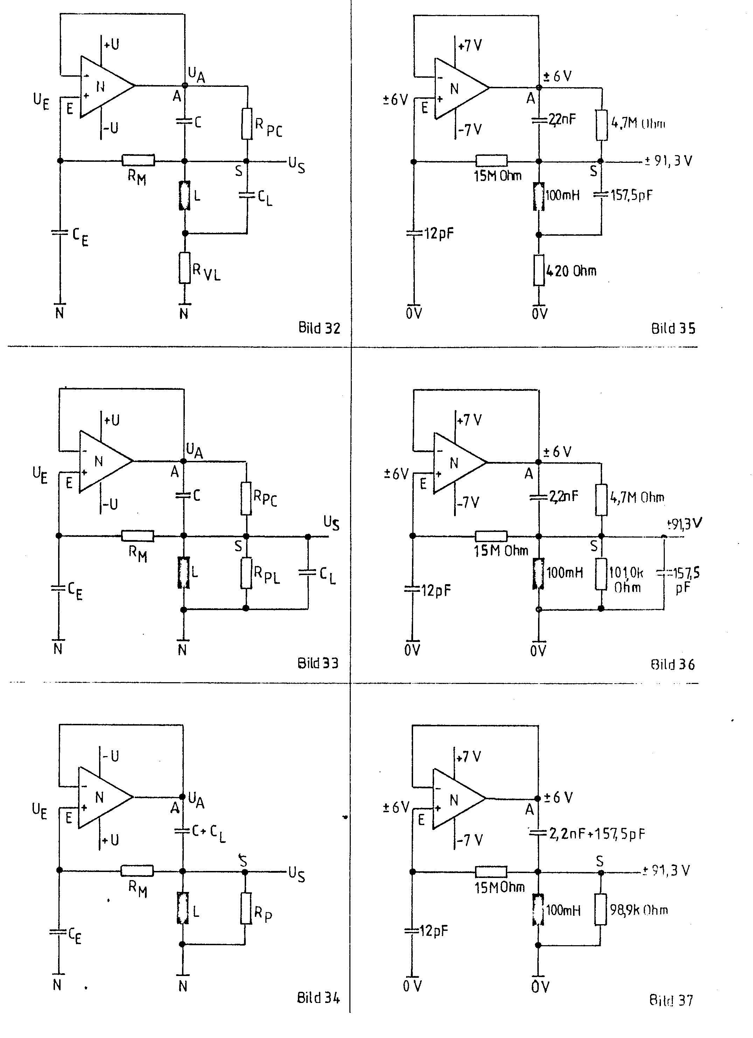

Durch eine geringfügige Abwandlung dieser Oszillatorschaltung (ein $R_M$-Widerstand zusätzlich - siehe Bild 31) ist jedoch eine Versorgungsgleichspannung +U zum Betreiben des neuen Oszillators ausreichend.

3.13 Berechnungsformeln für den neuen Oszilltor

A. Gegebene Größen:

1.  $L$ = Induktivität (H) mit

$q_L$ = Gütefaktor der Induktivität und

$R_{VL}$ = Verlustwiderstand der Induktivität (Ohm)

2.  $U_A$ = maximale Verstärkerausgangsspannung (V) und

$C_E$ = Verstärkereingangskapazität (F)

3.  $f_o$ = gewünschte Resonanzfrequenz (Hz)

B. Berechbare Größen:

1.  $C_L$ = Kapazität der Induktivität L

$$q_L = \frac{1}{R_{VL}} \cdot \sqrt{\frac{L}{C_L}}$$

$$(q_L \cdot R_{VL})^2 = \frac{L}{C_L}$$

$$C_L = \frac{L}{(q_L \cdot R_{VL})^2}$$

2.  $w_{max}$ = obere Grenzkreisfrequenz

$$w_{max} = \frac{1}{\sqrt{L \cdot C_L}}$$

$$= \frac{q_L \cdot R_{VL}}{L}$$

3.  $f_{max}$ = obere Grenzfrequenz

$$f_{max} = \frac{w_{max}}{2 \cdot 3,14}$$

4.  $C$ = Kapazität

$$w_o = \frac{1}{\sqrt{L \cdot (C + C_L)}}$$

$$w_o^2 \cdot L \cdot (C + C_L) = 1$$

$$C = \frac{1}{w_o^2 \cdot L} - C_L$$

$$= \frac{1}{(2 \cdot 3,14 \cdot f_o)^2 \cdot L} - C_L$$

gewählt  $C$ =

mit  $d_C$ = Verlustfaktor der Kapazität

5. $q_C$ = Gütefaktor der Kapazität

$$q_C = \frac{1}{d_C}$$

6. $w_o$ = korrigierte Kreisfrequenz

$$w_o = \frac{1}{\sqrt{L \cdot (C + C_L)}}$$

7. $f_o$ = korrigierte Resonanzfrequenz

$$f_o = \frac{w_o}{2 \cdot 3,14}$$

8. $R_{PL}$ = Parallelresonanzkreiswiderstand der Induktivität

$$R_{PL} = \frac{1}{R_{VL}} \cdot \frac{L}{C + C_L}$$

$$= \frac{(w_o \cdot L)^2}{R_{VL}}$$

9. $R_{PC}$ = Parallelresonanzkreiswiderstand der Kapazität

$$q_C = \frac{R_{PC}}{\frac{1}{w_o \cdot C}}$$

$$R_{PC} = \frac{q_C}{w_o \cdot C}$$

1o. $R_P$ = Parallelresonanzkreiswiderstand des Schwingkreises

$$R_P = \frac{R_{PL} \cdot R_{PC}}{R_{PL} + R_{PC}}$$

11. $q$ = Gütefaktor des Schwingkreises

$$q = R_P \cdot \sqrt{\frac{C + C_L}{L}}$$

$$= \frac{R_P}{w_o \cdot L}$$

12. $d$ = Dämpfungsfaktor des Schwingkreises

$$d = \frac{1}{q}$$

13. $V_o$ = Verstärkungsfaktor des Schwingkreises

$$V_o = q$$

14. $K_o$ = Rückkopplungsfaktor des Schwingkreises

$$K_o \geqq \frac{1}{q}$$

15. $U_o$ = Resonanzspannung des Schwingkreises

$$U_o = q \cdot U_A$$

0163803

16. $\Delta w$ = Kreisfrequenzdifferenz der Bandbreite

$$\Delta w = \frac{R_V}{L}$$

$$q = \frac{1}{R_V} \cdot \sqrt{\frac{L}{C + C_L}}$$

$$R_V = \frac{1}{q} \cdot \sqrt{\frac{L}{C + C_L}}$$

$$\Delta w = \frac{1}{q \cdot L} \cdot \sqrt{\frac{L}{C + C_L}}$$

$$= \frac{w_o}{q}$$

17. b = Frequenzdifferenz der Bandbreite

$$b = \frac{\Delta w}{2 \cdot 3,14}$$

18. $w_b$ = mittlere Kreisfrequenz der Bandbreite

$$w_b = \sqrt{(\frac{R_V}{2 \cdot L})^2 + w_o^2}$$

$$= \sqrt{(\frac{w_o}{2 \cdot q})^2 + w_o^2}$$

$$= w_o \cdot \sqrt{1 + \frac{1}{(2 \cdot q)^2}}$$

19. $f_b$ = mittlere Frequenz der Bandbreite

$$f_b = \frac{w_b}{2 \cdot 3,14}$$

20. $w_{bo}$ = Kreisfrequenzabweichung zwischen der mittleren Bandbreitenkreisfrequenz $w_b$ und der Resonanzkreisfrequenz $w_o$

$$w_{bo} = w_b - w_o$$

21. $f_{bo}$ = Frequenzabweichung zwischen der mittleren Bandbreitenfrequenz $f_b$ und der Resonanzfrequenz $f_o$

$$f_{bo} = \frac{w_{bo}}{2 \cdot 3,14}$$

22. $R_M$ = Mitkopplungswiderstand

$$R_M = \frac{L}{R_V \cdot C_E}$$

$$q = \frac{1}{R_V} \cdot \sqrt{\frac{L}{C + C_L}}$$

$$R_V = \frac{1}{q} \cdot \sqrt{\frac{L}{C + C_L}}$$

0163803

$$= \frac{\frac{w_o \cdot L}{q}}{}$$

$$R_M = \frac{L \cdot q}{w_o \, ; \, L \cdot C_E}$$

$$= \frac{q}{w_o \cdot C_E}$$

gewählt $R_M =$

23.  $U_S$ = Schwingkreisausgangsspannung bei Resonanz

$$U_S = \sqrt{U_A^2 + U_o^2}$$

$$= \sqrt{U_A^2 + q^2 \cdot U_A^2}$$

$$= U_A \cdot \sqrt{1 + q^2}$$

Hinweis:

Ergänzend zu den Berechnungsformeln gehören die Bilder 32 bis 34

3.14     Berechnungsbeispiel

A. Gegebene Werte:

1.     $L$  = Induktivität

         = 1oo mH mit

      $q_L$ = Gütefaktor der Induktivität

         = 6o und

      $R_{VL}$ = Verlustwiderstand der Induktivität = 42o Ohm

2.     $U_A$ = maximale Verstärkerausgangsspannung = 6 V und

      $C_E$ = Verstärkereingangskapazität = 12 pF

3.     $f_o$ = gewünschte Resonanzfrequenz

         = 1o kHz

B. Mit Hilfe der Berechnungsformeln errechnete Werte:

1.     $C_L$ = Kapazität der Induktivität L

$$C_L = \frac{1oo \cdot 1o^{-3}}{(6o \cdot 42o)^2}$$

$$= 1,5747 \cdot 1o^{-1o}$$

$$= 157,47 \text{ pF}$$

2.     $w_{max}$ = obere Grenzkreisfrequenz

$$w_{max} = \frac{6o \cdot 42o}{1oo \cdot 1o^{-3}}$$

$$= 2,52 \cdot 1o^5$$

$$= 252 \text{ kHz}$$

3.     $f_{max}$ = obere Grenzfrequenz

$$f_{max} = \frac{252 \cdot 1o^3}{2 \cdot 3,14}$$

$$= 4,o11 \cdot 1o^4$$

$$= 4o,11 \text{ kHz}$$

4.     $C$  = Kapazität

$$C = \frac{1}{(2 \cdot 3,14 \cdot 1o \cdot 1o^3)^2 \cdot 1oo \cdot 1o^{-3}}$$

$$- 157,47 \cdot 1o^{-12}$$

$$= 2,3756 \cdot 10^{-9}$$

$$= 2,3756 \text{ nF}$$

gewählt $C = 2,2$ nF

mit $\quad d_C$ = Verlustfaktor der Kapazität

$$= 1,5 \cdot 10^{-3}$$

5. $q_C$ = Gütefaktor der Kapazität

$$q_C = \frac{1}{1,5 \cdot 10^{-3}}$$

$$= 666,67$$

6. $w_0$ = korrigierte Kreisfrequenz

$$w_0 = \frac{1}{\sqrt{100 \cdot 10^{-3} \, (2,2 \cdot 10^{-9} + 157,47 \cdot 10^{-12})}}$$

$$= 6,5129 \cdot 10^4$$

$$= 65,129 \text{ kHz}$$

7. $f_0$ = korrigierte Resonanzfrequenz

$$f_0 = \frac{65,129 \cdot 10^3}{2 \cdot 3,14}$$

$$= 1,0366 \cdot 10^4$$

$$= 10,366 \text{ kHz}$$

8. $R_{PL}$ = Parallelresonanzkreiswiderstand der Induktivität

$$R_{PL} = \frac{(65,129 \cdot 10^3 \cdot 100 \cdot 10^{-3})^2}{420}$$

$$= 1,0099 \cdot 10^5$$

$$= 100,99 \text{ k Ohm}$$

9. $R_P$ = Parallelresonanzkreiswiderstand der Kapazität

$$R_{PC} = \frac{666,67}{65,129 \cdot 10^3 \cdot 2,2 \cdot 10^{-9}}$$

$$= 4,6528 \cdot 10^6$$

$$= 4,6528 \text{ M Ohm}$$

10. $R_P$ = Parallelresonanzkreiswiderstand des Schwingkreises

$$R_P = \frac{100,99 \cdot 10^3 \cdot 4,6528 \cdot 10^6}{100,99 \cdot 10^3 + 4,6528 \cdot 10^6}$$

$$= 9,8845 \cdot 10^4$$

$$= 98,845 \text{ k Ohm}$$

11. $q$ = Gütefaktor des Schwingkreises

$$q = \frac{98,845 \cdot 10^3}{65,129 \cdot 10^3 \cdot 100 \cdot 10^{-3}}$$

$$= 15,177$$

12. $d$ = Dämpfungsfaktor des Schwingkreises

$$d = \frac{1}{15,177}$$

$$= 0,06589$$

13. $V_o$ = Verstärkungsfaktor des Schwingkreises

$$V_o = 15,177$$

14. $K_o$ = Rückkopplungsfaktor des Schwingkreises

$$K_o \gtreqless 0,06589$$

15. $U_o$ = Resonanzspannung des Schwingkreises

$$U_o = 15,177 \cdot 6$$

$$= 91,061 \ V$$

16. $\triangle w$ = Kreisfrequenzdifferenz der Bandbreite

$$\triangle w = \frac{65,129 \cdot 10^3}{15,177}$$

$$= 4291,30 \ Hz$$

17. $b$ = Frequenzdifferenz der Bandbreite

$$b = \frac{4291,30}{2 \cdot 3,14}$$

$$= 682,98 \ Hz$$

18. $w_b$ = mittlere Kreisfrequenz der Bandbreite

$$w_b = 65,129 \cdot 10^3 \cdot \sqrt{1 + \frac{1}{(2 \cdot 15,177)^2}}$$

$$= 6,5164 \cdot 10^4$$

$$= 65,164 \ kHz$$

19. $f_b$ = mittlere Frequenz der Bandbreite

$$f_b = \frac{65,164 \cdot 10^3}{2 \cdot 3,14}$$

$$= 1,0371 \cdot 10^4$$

$$= 10,371 \ k \ Hz$$

20. $w_{bo}$ = Kreisfrequenzabweichung zwischen der mittleren Bandbreitenkreisfrequenz $w_b$ und der Resonanzkreisfrequenz $w_o$

$$w_{bo} = 65,164 \cdot 10^3 - 65,129 \cdot 10^3$$

$$= 35 \ Hz$$

21. $f_{bo}$ = Frequenzabweichung zwischen der mittleren Bandbreitenfrequenz $f_b$ und der Resonanzfrequenz $f_o$

$$f_{bo} = \frac{35}{2 \cdot 3{,}14}$$
$$= 5{,}57 \text{ Hz}$$

22. $R_M$ = Mitkopplungswiderstand

$$R_M \leqq \frac{15{,}177}{65{,}129 \cdot 10^3 \cdot 12 \cdot 10^{-12}}$$
$$\leqq 1{,}9419 \cdot 10^7$$
$$\leqq 19{,}419 \text{ M Ohm}$$

gewählt $R_M$ = 15 M Ohm

23. $U_S$ = Schwingkreisausgangsspannung bei Resonanz

$$U_S = 6 \cdot \sqrt{1 + 15{,}177^2}$$
$$= 91{,}26 \text{ V}$$

**Hinweis:**

Ergänzend zum Berechnungsbeispiel gehören die Bilder 35 bis 37

-39-  0163803

Inhaltsverzeichnis

1.   Patentansprüche aus der Erfindung

2.   Beschreibung der Erfindung
2.1  Einsatzbereich des neuen Oszillators
2.2  Stand der Technik
2.3  Allgemeiner Aufbau von Sinusoszillatoren
2.4  Aufbau des neuen Oszillators
2.5  Funktionsweise des neuen Oszillators
2.6  Die vier Schwingkreisspannungen des neuen Oszillators
2.7  Reihenschwingkreis-Funktion des neuen Oszillators
2.8  Parallelschwingkreis-Funktion des neuen Oszillators

3.   Rechnerische Abhandlung der Erfindung
3.1  Parallelresonanzkreiswiderstand $R_P$
3.2  Zusammenhang zwischen der Resonanzspannung $U_o$ des Schingkreises und der Verstärkerausgangsspannung $U_A$ beim neuen Oszillator
3.3  Dämpfungsfaktor d des Schwingkreises
3.4  Gütefaktor q des Schwingkreises
3.5  Kreisfrequenzdifferenz $\triangle$ w der Bandbreite beim Reihenschwingkreis
3.6  Kreisfrequenzdifferenz $\triangle$ w der Bandbreite beim Parallelschwingkreis
3.7  Mittlere Kreisfrequenz $w_b$ der Bandbreite
3.8  Bandbreite b, Dämpfungsfaktor d und Gütefaktor q des Schwingkreises, mit Hilfe des $\triangle$ w-Wertes definiert
3.9  Mitkopplungswiderstand $R_M$ des neuen Oszillators
3.1o Kreisverstärkung $V_o \cdot K_o$ des neuen Oszillators
3.11 Frequenzverhalten des neuen Oszillators
3.12 Versorgungsgleichspannung $^+_-U$ bzw. Versorgungsgleichspannung +U des neuen Oszillators
3.13 Berechnungsformeln für den neuen Oszillator
3.14 Berechnungsbeispiel

4.   Zeichnungen zum beschreibenden Text

5.   Zusammenfassung der Erfindung

## 1. Patentansprüche aus der Erfindung

Die Patentansprüche beziehen sich auf einen Sinusoszillator zur Erzeugung von ungedämpften elektrischen Schwingungen, dadurch gekennzeichnet,

1. daß sein einfacher, unkomplizierter schaltungstechnischer Aufbau (siehe Zusammenfassung der Erfindung - Prinzipschaltbild, Version 1) nur wenige elektronische Bauelemente erfordert (ein Operationsverstärker N, eine Kapazität C, eine Induktivität L und ein Widerstand $R_M$ - $C_E$ ist die Verstärkereingangskapazität)

2. daß sein LC-Schwingkreis funktionsmäßig eine Kombination aus Reihen- und Parallelschwingkreis darstellt, dh., daß dieser Schwingkreis als Reihenresonanzkreis infolge seines niedrigen Reihenresonanzkreiswiderstandes innerhalb des Versorgungsspannungsbereichs $^+_-U$ über den Operationsverstärker N hohe Leistung aufnimmt, so daß dieser Schwingkreis als Parallelresonanzkreis verzerrungsfrei weit über den Versorgungsspannungsbereich $^+_-U$ hinaus schwingt, ohne daß hierbei zur Vermeidung von Verzerrungen eine Begrenzung der Parallelschwingkreisamplitude durch eine zusätzlich vorzusehende Amplitudenbegrenzungsschaltung erforderlich ist

3. daß bei seinem stabilen Schwingverhalten und seinen guten Schwing- und Abgleicheigenschaften Verzerrungen der Sinusschwingungen durch eine Übersteuerung seines Operationsverstärkers N nicht gegeben sind, da die Verstärkerausgangsspannung gleich der niedrigen Reihenresonanzkreisspannung ist und eine Rückwirkung der hohen Parallelresonanzkreisspannung auf den Verstärkerausgang A infolge der entgegengesetzten Polarität der beiden gleich großen, über der Schwingkreiskapazität C und -induktivität L wirkenden Resonanzspannungen nicht besteht

4. daß bei Einstellung seiner Resonanzfrequenz über die Schwingkreiskapazität C, z.B. bei Abstimmung des Schwingkreises auf eine vorgegebene Festfrequenz, die Parallelresonanzkreisspannungsamplitude innerhalb des Einstellbereichs weitgehend konstant bleibt und daß bei dynamischer Veränderung seiner Resonanzfrequenz über die Schwingkreiskapazität C, z.B. durch Zuschalten eines Kondensatormikrophons, eine Frequenzmodulation mit konstanter Parallelresonanzkreisspannungsamplitude möglich ist

5. daß bei Rückführung seiner vollen Parallelresonanzkreisausgangsspannung über den hochohmigen Mitkopplungswiderstand $R_M$ auf den Eingang E des Operationsverstärkers N dieser Mitkopplungswiderstand in Verbindung mit der Eingangskapazität $C_E$, die sämtliche zwischen Schwingkreisausgang S und Verstärkerausgang A befindlichen kapazitiven Größen des Mitkopplungszweiges berücksichtigt (Leitungskapazitäten, Frequenzverhalten des Operationsverstärkers usw.), den Phasenwinkel und die Amplitudengröße der Parallelresonanzkreisausgangsspannung so verändert, daß die Verstärkerausgangsspannung der Reihenresonanzkreisspannung entspricht

6. daß eine Spannungsverstärkung durch den Operationsverstärker N nicht erbracht werden muß, da die auf den Verstärkereingang E zurückgeführte Parallelresonanzkreisausgangsspannung annähernd um den Gütefaktor des Schwingkreises größer als die Verstärkerausgangsspannung ist, die der Reihenresonanzkreisspannung entspricht

7. daß bedingt durch die Anordnung der Schwingkreiskapazität C am Operationsverstärkerausgang A die Induktivität L von keinem Gleichstrom durchflossen wird und somit eine Änderung der Resonanzfrequenz des Schwingkreises durch eine Vormagnetisierung dieser Induktivität nicht gegeben ist

8. daß beim Einsatz eines Operationsverstärkers mit leistungsstarker (gegebenenfalls im Schaltbetrieb arbeitender) Gegentaktendstufe und entsprechend dimensioniertem Schwingkreis hohe Leistung zur Erzeugung von kapazitiver bzw. induktiver Wärme (z.B. bei Hochfrequenztrocknung, -verleimung bzw. -härtung), zur Erzielung hoher Sendeleistung usw. erreicht wird

9. daß bei einer geringfügigen Abwandlung seiner Schaltung (ein hochohmiger Mitkopplungswiderstand $R_M$ zusätzlich) eine Versorgungsspannung +U zu seinem Betreiben ausreicht (siehe Zusammenfassung der Erfindung - Prinzipschaltbild, Version 2)

1o. daß durch geringe Abänderung seiner Schaltung, Anschluß S des Mitkopplungswiderstandes direkt auf Nullpotential N (Unterbrechung des Mitkopplungszweigs), kapazitive Signaleinkopplung auf den nicht invertierenden Operationsverstärkereingang

-42-                                    0163803

E und gegebenenfalls (sofern erforderlich) einem Verstärkungsfaktor V   1 des Operationsverstärkers N, dieser Oszillator
in einen selektiven Verstärker umfunktioniert wird (Die Patentansprüche gelten somit ebenfalls für selektive Verstärker
nach diesem Prinzip)

4. Zeichnungen

Die zum beschreibenden
Text gehörenden Bilder,
durchnummeriert von 1 bis 37

Bild 1

Bild 2

Bild 3

Bild 4

Bild 5

Bild 6

Bild 7

0163803

Bild 8

Bild 9

Bild 10

Bild 12

Bild 11

Bild 13

Bild 14

Bild 15

Bild 17

Bild 16

Bild 18

Bild 19

Bild 20

Bild 21

Bild 22

Scheinwiderstand Z des Reihenschwingkreises

in Abhängigkeit von der Kreisfrequenz w

$X_L = w \cdot L$

$Z = \sqrt{R_V^2 + (X_L - X_C)^2}$

$\Delta w$

$\dfrac{\Delta w}{2}$

$\sqrt{2} \cdot R_V$

$X_C = \dfrac{1}{w \cdot C}$

$R_V$

$w_1 \quad w_0 \quad w_b \quad w_2$

$w \rightarrow$

Bild 23

3/6

0163803

Scheinleitwert Y des Parallelschwingkreises

in Abhängigkeit von der Kreisfrequenz w

$B_C = w \cdot C$

$Y = \sqrt{\dfrac{1}{R_P^2} + (B_C - B_L)^2}$

$B_L = \dfrac{1}{w \cdot L}$

$\dfrac{1}{R_R}$

$\sqrt{2} \cdot \dfrac{1}{R_P}$

$\Delta_w$

$\dfrac{\Delta_w}{2}$

$w_1 \quad w_0 \quad w_b \quad w_2$

$w$

$Y$

Bild 24

5/6    0163803

Bild 25

Bild 26

Bild 27

Bild 28

Bild 29

Bild 30

Bild 31

Bild 32

Bild 33

Bild 34

Bild 35

Bild 36

Bild 37